# DEMANDE DE BREVET EUROPEEN

(11) **EP 0 872 881 A1**
(43) Date de publication de la demande: **21.10.1998**
(21) Numéro de dépôt: 98410040.4
(22) Date de dépôt: 14.04.1998
(51) Int. Cl.: H01L 21/331

(54) **Procédé de fabrication d'un transistor bipolaire et de son contact d'émetteur**

(30) Priorité: 15.04.1997 FR 9704913
(71) Demandeur: SGS-THOMSON MICROELECTRONICS S.A., 94250 Gentilly (FR); FRANCE TELECOM, 75015 Paris (FR)
(72) Inventeur: Laurens, Michel, 38120 Saint Egrève (FR)
(74) Mandataire: de Beaumont, Michel

(57) **Abrégé**

L'invention concerne un procédé de fabrication d'un transistor bipolaire dans un circuit intégré consistant à former la zone de base (3) de type P ; revêtir cette zone de base d'une couche isolante (5) ; former une ouverture (6) dans la couche isolante à l'emplacement où l'on veut former l'émetteur ; revêtir la structure d'une couche de silicium polycristallin dopé N ; graver la couche de silicium polycristallin pour en délimiter une portion (10) ; former des espaceurs (12) autour de la portion de silicium polycristallin ; et implanter (16) un dopant de type P pour former une région de prise de contact de base (14), après avoir masqué (21) la portion de silicium polycristallin (10) au-dessus de la zone où elle est en contact avec la zone de base.

## Description

La présente invention concerne la fabrication des circuits intégrés et plus particulièrement des transistors bipolaires. Elle s'applique notamment à la réalisation de transistors bipolaires dans des circuits intégrés en technologie mixte bipolaire/MOS (BICMOS) dont les dimensions élémentaires sont submicroniques, c'est-à-dire que la plus petite dimension peut être de l'ordre de 0,2 à 0,5 µm.

L'invention concerne plus particulièrement des transistors bipolaires dont l'émetteur est formé par diffusion à partir d'une couche de silicium polycristallin dopé.

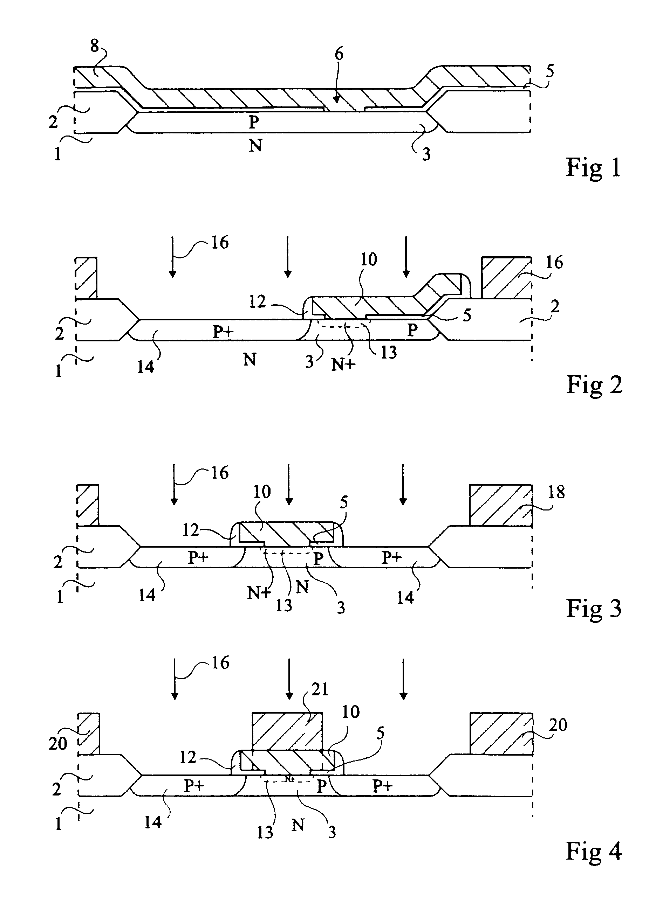

Les figures 1 et 2 représentent des étapes de fabrication d'un transistor bipolaire NPN et plus particulièrement de son contact d'émetteur, telles que décrites dans la demande de brevet français N° 97/02637 déposée le 28 février 1997 au nom de la demanderesse.

Etant donné une région supérieure d'une couche épitaxiée 1 délimitée par une zone d'oxyde épais 2, on a formé dans la surface de la couche épitaxiée de type N, une région de base 3 de type P. La structure est revêtue d'une couche isolante 5 dans laquelle est formée une ouverture 6 et l'ensemble est revêtu d'une couche de silicium polycristallin 8 fortement dopé de type N⁺. Ceci est représenté en figure 1.

Dans une étape ultérieure, illustrée en figure 2, on grave la couche de silicium polycristallin 8 pour laisser en place un plot de silicium polycristallin 10. Ce plot doit être suffisamment large pour être certain qu'il n'est pas plus étroit que l'ouverture 6 et pour permettre de prendre ultérieurement un contact sur sa surface supérieure par l'intermédiaire d'un via gravé dans une couche isolante. Après quoi, on forme des espaceurs latéraux 12 à la périphérie du plot de silicium polycristallin 10. On forme ensuite par un recuit thermique rapide une diffusion d'émetteur 13 dans la base 3 à partir du silicium polycristallin.

La figure 3 représente une structure ayant les mêmes caractéristiques fonctionnelles que celles de la figure 2 sauf que la zone d'émetteur a été représentée sensiblement au centre de la zone de base et a donc une allure sensiblement symétrique. Dans la figure 3, de mêmes éléments sont désignés par de mêmes références qu'en figure 2.

Dans une réalisation pratique, l'ouverture 6 dans la couche isolante 5 a par exemple une largeur de l'ordre de 0,5 µm et la couche isolante 5 a par exemple une épaisseur de l'ordre de 80 nm à 120 nm.

Pour être sur que le plot de silicium polycristallin 10 déborde par rapport à l'ouverture 6, on le grave normalement à partir d'un masque dont les dimensions latérales sont supérieures de 0,3 µm de chaque côté par rapport aux dimensions de l'ouverture. Ainsi, ce plot a une largeur de sensiblement 1,1 µm. Il peut avoir une même longueur ou être de forme rectangulaire.

A une étape ultérieure du procédé, on cherche à former une région à plus fort niveau de dopage 14 pour la reprise du contact de base. Ceci est réalisé par une implantation 16, par exemple une implantation de bore. On a représenté en dehors de la zone d'émetteur-base une couche de résine 16. Cette couche de résine est destinée à masquer d'autres zones du circuit intégré formé dans la même plaquette de silicium.

Dans la filière de fabrication décrite précédemment, on a considéré que, étant donné que la couche de silicium polycristallin 10 est très fortement dopée de type N par une implantation d'arsenic, l'implantation de bore 16 n'est pas susceptible d'inverser son type de polarité et de perturber la réalisation de la diffusion d'émetteur fortement dopée de type N⁺.

Toutefois, la demanderesse a observé des défauts sur ce type de composant qui n'atteignaient pas les spécifications prévues, notamment en ce qui concerne leur gain, et a cherché à y remédier. C'est là l'objet de la présente invention.

Ainsi, la présente invention prévoit un procédé de fabrication d'un transistor bipolaire dans un circuit intégré comprenant les étapes consistant à former la zone de base du premier type de conductivité du transistor ; revêtir cette zone de base d'une couche isolante ; former une ouverture dans la couche isolante à l'emplacement où l'on veut former la région d'émetteur ; revêtir la structure d'une couche de silicium polycristallin dopé selon le deuxième type de conductivité ; graver la couche de silicium polycristallin pour en délimiter une portion selon un contour choisi ; former des espaceurs à la périphérie de ladite portion de silicium polycristallin ; et implanter un dopant du premier type de conductivité pour former une région de prise de contact de base. L'implantation est réalisée après avoir formé un masque recouvrant partiellement le plot de silicium polycristallin, au moins au-dessus de la zone où il est en contact avec la zone de base.

Selon un mode de réalisation de la présente invention, le silicium polycristallin est dopé à l'arsenic et la région de contact de base est dopée au bore.

Selon un mode de réalisation de la présente invention, la couche isolante et les espaceurs sont en oxyde de silicium.

Selon un mode de réalisation de la présente invention, la couche isolante et les espaceurs sont en nitrure de silicium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 3 décrites précédemment illustrent des étapes d'un procédé de fabrication d'un transistor NPN selon l'art antérieur (demande de brevet non publiée).
La figure 4 illustre une étape d'un procédé de fabrication d'un transistor NPN selon la présente invention.

La figure 4 désigne les mêmes éléments que ceux de la figure 3 avec les mêmes références. La seule différence est que la couche de résine de masquage 18 est remplacée par une couche de résine de masquage 20 qui comprend une portion formée sur la surface supérieure du plot de silicium polycristallin 10.

En effet, comme on l'a indiqué précédemment, on a noté que le transistor NPN illustré en figures 2 et 3 présentait en fait un gain moins élevé que ce à quoi on pouvait s'attendre.

Des expériences effectuées par la demanderesse ont montré que ce gain moins élevé résultait essentiellement de l'implantation de bore 16 qui modifiait le dopage de la couche d'émetteur 13 et qui pouvait même aller jusqu'à créer une couche fantôme d'inversion. Pour remédier à cet inconvénient, la demanderesse a d'abord essayé de former une couche de masquage auto-alignée sur le plot 10, et a tenté de conserver la couche de résine photosensible ayant servi à la délimitation du plot 10. Toutefois, ceci s'est avéré incompatible avec les étapes de gravure de la couche isolante 5, que celle-ci soit une couche d'oxyde de silicium ou une couche de nitrure de silicium.

Ainsi, dans un premier temps, la demanderesse a tenté d'optimiser l'implantation de bore 16 pour éviter l'inconvénient susmentionné, étant donné que la très petite dimension du plot 10 semblait rendre impossible un masquage sensiblement conforme de ce plot. Mais ceci a conduit à des défauts de dopage des grilles de transistors MOS dopées simultanément.

Ensuite, et selon la présente invention, la demanderesse a noté qu'il n'était pas nécessaire de masquer complètement le plot 10 mais qu'il suffisait de masquer sa partie centrale, comme cela est représenté en figure 4. En effet, même s'il se produit une implantation de type P sur les bords du plot de silicium polycristallin, dans la zone qui surplombe l'isolant 5, ceci est sans inconvénient sur la structure car cette zone du plot de silicium polycristallin ne contribue pas au dopage de l'émetteur et ne peut s'étendre suffisamment pour perturber la zone utile. Ainsi, la présente invention prévoit de disposer un plot de résine 21 dont les dimensions sont inférieures de 0,1 à 0,2 µm à celles du plot de silicium polycristallin, ce qui est compatible avec la filière utilisée dans laquelle la précision d'alignement des masques est de l'ordre de 0,15 µm.

Bien entendu, la présente invention est susceptible de diverses variantes et modifications qui apparaîtront à l'homme de l'art. Par exemple, la couche isolante 5 peut être une couche de nitrure de silicium comme cela est utilisé dans la demande de brevet susmentionnée ou une couche d'oxyde de silicium comme cela est exposé dans l'état de l'art antérieur cité dans la demande de brevet susmentionnée.

## Revendications

1. Procédé de fabrication d'un transistor bipolaire dans un circuit intégré comprenant les étapes suivantes :
former la zone de base (3) du premier type de conductivité du transistor ;
revêtir cette zone de base d'une couche isolante (5) ;
former une ouverture (6) dans la couche isolante à l'emplacement où l'on veut former la région d'émetteur ;
revêtir la structure d'une couche de silicium polycristallin dopé selon le deuxième type de conductivité ;
graver la couche de silicium polycristallin pour en délimiter une portion (10) selon un contour choisi ;
former des espaceurs (12) à la périphérie de ladite portion de silicium polycristallin ; et
implanter (16) un dopant du premier type de conductivité pour former une région de prise de contact de base (14) ;
caractérisé en ce que l'implantation est réalisée après avoir formé un masque (21) recouvrant partiellement le plot de silicium polycristallin (10), au moins au-dessus de la zone où il est en contact avec la zone de base.

2. Procédé selon la revendication 1, caractérisé en ce que le silicium polycristallin (10) est dopé à l'arsenic et en ce que la région de contact de base est dopée au bore.

3. Procédé selon la revendication 1, caractérisé en ce que la couche isolante et les espaceurs sont en oxyde de silicium.

4. Procédé selon la revendication 1, caractérisé en ce que la couche isolante et les espaceurs sont en nitrure de silicium.
